Europäisches Patentamt

European Patent Office

Office européen des brevets

(11) Publication number: **0 154 318**
**B1**

## EUROPEAN PATENT SPECIFICATION

(45) Date of publication of patent specification: **04.01.89**

(21) Application number: **85102411.7**

(22) Date of filing: **04.03.85**

(51) Int. Cl.⁴: **H 03 C 5/00,** H 03 D 5/00,
H 04 N 5/40, H 04 N 9/80

(54) **High frequency modulation circuit.**

(30) Priority: **05.03.84 JP 40413/84**

(43) Date of publication of application:
**11.09.85 Bulletin 85/37**

(45) Publication of the grant of the patent:
**04.01.89 Bulletin 89/01**

(84) Designated Contracting States:
**DE FR GB**

(56) References cited:
**DE-A-3 238 920**
**FR-A-2 502 423**
**GB-A-1 338 201**

**SIEMENS COMPONENTS, annual 22, no. 5,
September 1984, Berlin, München
"Anpassungsfähiger Modulator-baustein TDA
5660P für Fernseh-Bil- und Tonsignale (48 bis
860 MHz)", pages 228, 229**

(73) Proprietor: **ALPS ELECTRIC CO., LTD.
1-7 Yukigaya Otsuka-cho
Ota-ku Tokyo 145 (JP)**

(72) Inventor: **Yamaguchi, Yoshinobu
10-3 Aza-Sakae-cho Kakuda
Kakuda-shi Miyagi-ken (JP)**

(74) Representative: **Klunker, Hans-Friedrich, Dr.
Patentanwälte Klunker . Schmitt-Nilson . Hirsch
Winzererstrasse 106
D-8000 München 40 (DE)**

# Description

The present invention relates to a high frequency modulation circuit which is capable of easily changing the modulation system for voice and video signals in accordance with different television systems so that it can be used for television receivers designed for different television systems.

On the occasion of reproducing a recorded picture by applying a reproduced signal sent from a VTR (video tape recorder) or video disk unit, if a receiver is designed in the NTSC system, for example, the video signal and voice signal are modulated by a high frequency modulation circuit of the NTSC system and are then applied to the receiver. If a receiver is designed in the PAL system, the signals are modulated by a high frequency modulation circuit of the PAL system. If a receiver is designed in the SECAM system, the signals are modulated by a high frequency modulation circuit of the SECAM system. As described above, a high frequency modulation circuit must be prepared in accordance with the particular television system. Accordingly, in Europe where several kinds of television systems are employed, users are caused to buy a high frequency modulation circuit corresponding to the particular television system, and manufacturers of high frequency modulation circuit cannot realize cost-down due to the production of many kinds of circuits. Moreover, users must buy a television set providing the high frequency modulation circuit corresponding to the particular television system, suffering from economical burden.

In regard of different kinds of television systems it has already been proposed to combine certain parts of a demodulating circuit designed for the PAL system and a demodulating circuit designed for the SECAM system (FR—A1—2 502 423). However, this system can be used only for demodulating signals of said two systems.

The applicant of the first invention has already proposed a high frequency modulator for video tape recorders in which two different audio frequencies are generated by a common tuning circuit. The tuning circuit comprises a switch the position of which determines the resonance frequency of the tuning circuit.

It is the problem underlying the present invention to provide a high frequency modulation circuit switchable to at least two different modes of modulation, which is able to generate a television signal in accordance with a selected television system.

According to the invention, high frequency modulation circuit switchable to at least two different modes of modulation, is characterized in that a modulating signal is applied to two switching circuits each of which is switchable between an ON-state in which the applied modulating signal can pass, and an OFF-state in which the applied modulating signal is blocked, that a carrier wave is frequency-modulated by the output signal of a first one of the switching circuits and is amplitude-modulated by the output signal of the second switching circuit, and that the switching circuits are switched to different switching states by means of a switching-signal.

Each of the switching circuits can comprise an amplifying transistor operated as an emitter follower amplifier, and a switching transistor switching the amplifier transistor into an amplifying state or an OFF-state under the control of the switching signal and the inverted switching signal, respectively.

The transistors of the switching circuits can be arranged as a transistor array.

The output of the first switching circuit can be connected to the modulation signal input of a frequency modulator and the output of the second switching circuit and the output of the frequency modulator can be connected to the input of an amplitude modulator the output signal of which is amplitude-modulated when the second switching circuit is in the ON-state and is frequency-modulated when the first switching circuit is in the ON-state.

The frequency of the carrier wave to be modulated can be switchable between at least two frequencies by means of the switching signal.

The frequency of the carrier wave can be determined by a tank circuit comprising a first coil and connected in parallel thereto a series connection between a second coil and an electronic switch the switching state of which is controlled by the switching signal.

The carrier wave to be modulated can be the voice sub-carrier and the modulating signal can be the voice signal of a television signal, and the amplitude-modulated or frequency-modulated voice sub-carrier and a video-signal can be applied to a picture signal modulator modulating a television signal carrier.

The picture signal modulator can be switchable between positive modulation and negative modulation and the switching condition of the picture signal modulator can be controlled by the switching signal.

The invention, further developments and advantages of the invention as well as further aspects of the problem to be solved by the invention will be elucidated by means of the following description of the exemplary embodiments of the invention.

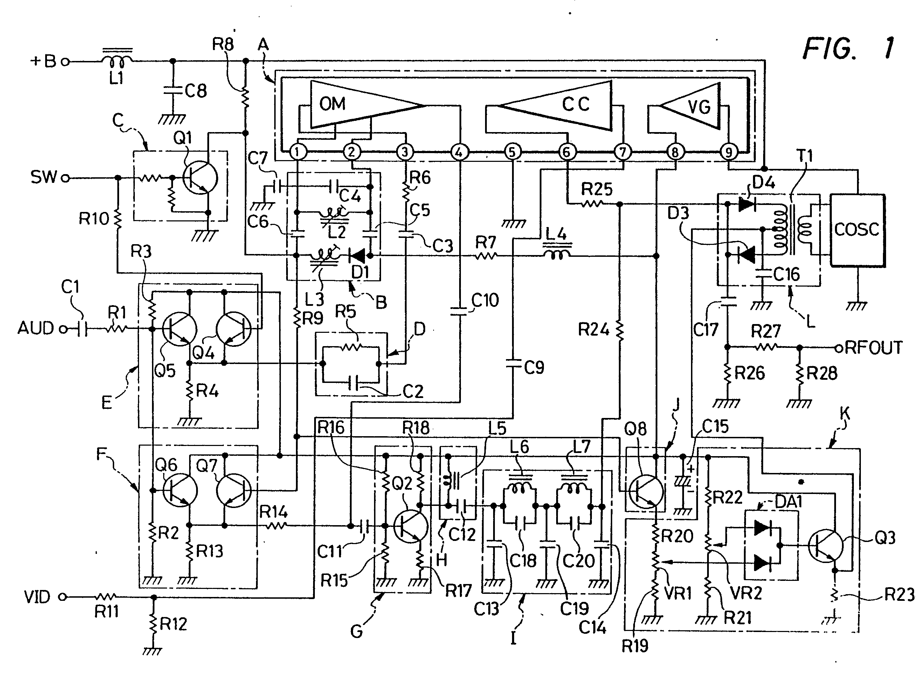

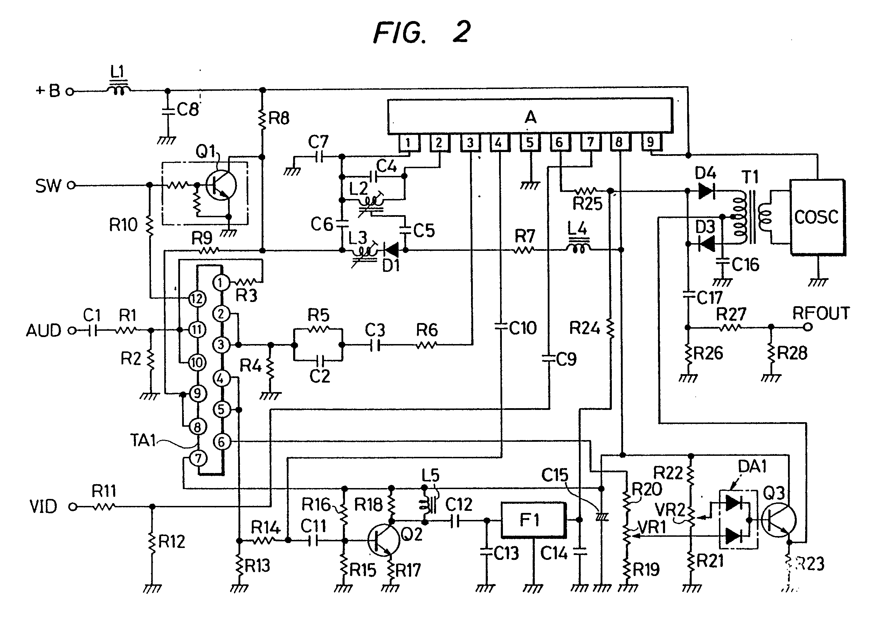

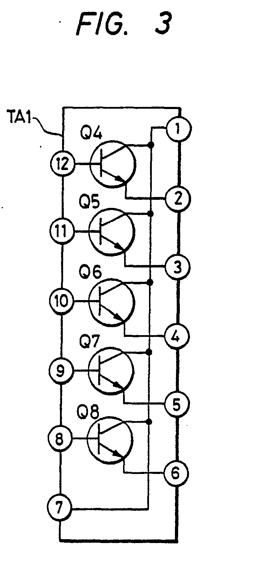

Fig. 1 is a schematic diagram of an embodiment of the present invention. Fig. 2 is a schematic diagram of an embodiment employing a transistor array. Fig. 3 is a transistor array.

For the sake of shortness of the description, explicit reference to the drawings is made here as regards the particular arrangements of the components of the circuit diagrams in Fig. 1 to 3 and their particular interconnection.

Fig. 1 is a schematic diagram of an embodiment of the present invention, indicating a high frequency modulation circuit which is changing over to the PAL system and the SECAM system. In this figure, A to L denote blocks, COSC is a carrier oscillator, Q1 to Q8 are transistors, C1 to C20 are capacitors, L1 to L7 are coils, D1 to D4 are diodes, R1 to R28 are resistors, VR1 to VR2 are variable resistors, DA1 is a diode array, +B is a power supply voltage, for example, of 9V, SW is a change-over terminal which supplies the switching signal, AUD is an input terminal of a voice signal, VID is an input terminal of a video signal, RFOUT is an output terminal.

The block A is integrated as a circuit containing a regulated power supply circuit VG, a video signal clamp and white clip circuit CC, a voice sub-carrier generator and a frequency modulation circuit OM. 1 to 9 indicate terminals. The block B forms a tank circuit connected to the terminals 1 and 2 of block A. This tank circuit is composed of coils L2 and L3, capacitors C4 to C6 and a diode D1. The connection of coil L3 is controlled by the diode D1. The regulated power supply circuit VG outputs, for example, a voltage of 5.3V to the terminal 8.

The block C is composed of a transistor Q1 which turns ON and OFF in accordance with a switching signal applied to the switching terminal SW. When it is ON, a forward current flows through the diode D1 and therefore coil L3 is connected in parallel to coil L2 through the capacitors C5 and C6. When it is OFF, reverse bias is applied to the diode D1 and thereby the coil L3 is separated.

The block D forms a preemphasis circuit and comprises a resistor R5 and a capacitor C2. The blocks E and F form buffer amplifiers and switching circuits for the voice signal and comprise transistors Q4 to Q7. The block G forms an amplitude modulator and comprises a transistor Q2. The block H forms a high-pass-filter and comprises a coil L5 and a capacitor C12. The block I forms a low-pass-filter and comprises coils L6 to L7, capacitors C13 to C14, C18 to C20. The block J forms a switch circuit and comprises a transistor Q8.

The block K forms a bias switching circuit and comprises a transistor Q3, a diode array DA1 and variable resistors VR1 to VR2, etc. A voltage to be applied to the diode array DA1 by the variable resistor VR1 when the transistor Q8 is ON is set higher than a voltage to be applied to the diode array DA1 by the variable resistor VR2, and this voltage is applied to the base of transistor Q3 through the diode array DA1. For example, a voltage to be applied to the base of transistor Q3 through the diode array DA1 when the transistor Q8 is ON is set to 2.586V, while a voltage to be applied to the base of transistor Q3 through the diode array DA1 when the transistor Q8 is OFF is set to 1.592V. The block L forms a picture signal modulation and mixer and comprises diodes D3 to D4, a capacitor C16 and a transformer T1. This block L performs negative modulation by a bias sent from the block K when the transistor Q8 is ON and also performs positive modulation by a bias sent from the block K when the transistor Q8 is OFF.

If a low level signal is applied to the switching terminal SW, the modulation circuit is switched to the modulation of the PAL system. If a high level signal is applied to the switching terminal SW, the modulation circuit is switched to the modulation of the SECAM system. If the switching terminal SW is set to a low level, the transistor Q1 of block C and the transistor Q4 of block E become OFF, while the transistor Q7 of block F and the transistor Q8 of block J become ON. As a result, in the block K, the emitter voltage of transistor Q3 is determined by a voltage applied to the diode array DA1 through the variable resistor VR1. Since this emitter voltage is supplied to the center point of transformer T1 of block L, the block L operates as a modulator of the PAL system, namely as the video signal modulator of a negative modulation system.

When the transistor Q7 of block F turns ON, the emitter voltage of transistor Q6 rises up to a value near the collector voltage, the base and the emitter are reversely biased and the block F becomes non-operative. Meanwhile, since the transistor Q4 of block E is OFF, the transistor Q5 operates as an emitter follower amplifier. The voice signal input to the input terminal AUD is applied to the voice sub-carrier generator and frequency modulation circuit OM of the block A from the terminal 3 of block E through the block D forming the preemphasis circuit.

A video signal input to the input terminal VID is applied to the terminal 7 of block A through a resistor R11 and a capacitor C9. This signal is further applied to the block L from the terminal 6 through the resistor R25 after it has been processed by the video signal clamp and white clip circuit CC.

In the block B, the potential at the connecting point of resistors R8 and R9 is set higher than a voltage at the terminal 8 of block A and therefore the diode D1 becomes OFF due to a reverse bias applied thereto. Accordingly, coil L2 and capacitor C4 form a tank circuit and a resonant frequency of this tank circuit is, for example, 5.5 MHz.

A voice sub-carrier signal which is frequency modulated by a voice signal is output to the terminal 4 from the voice sub-carrier generator and frequency modulation circuit OM of the block A and is then applied to the block G forming an amplitude modulator through the capacitors C10, C11. However, since the block F is in the non-operative condition, the transistor Q6 does not output a voice signal and a frequency modulated voice sub-carrier signal is output to the block H forming a high-pass-filter from the collector of transistor Q2 of block G. This block H prevents generation of sound fringe due to a leak of voice signal to the video modulator and mixer. An output signal of this block H is applied to the block I forming a low-pass-filter and is then applied to the block L through a resistor R24.

Therefore, an output signal of the video signal clamp and white clip circuit CC and an output signal of the block I forming the low-pass-filter are applied to the block L and a carrier signal in the UHF band sent from the carrier generator COSC is also applied thereto. Thereby, a signal modulated in accordance with the PAL system is output to the output terminal RFOUT.

When the switching terminal SW is set to a high level, the transistor Q1 of block C becomes ON, the transistor Q4 of block E becomes ON, the transistor Q7 of block F becomes OFF and the transistor Q8 of block J becomes OFF. When the transistor Q1 becomes ON, the potential at the connecting point of resistors R8 and R9 becomes almost zero and a forward voltage is applied to the diode D1 which becomes ON, causing the coil L3 to be connected in parallel to the coil L2. Thereby, the resonant frequency of tank circuit of block B becomes, for example, 6.5 MHz.

A voice signal applied to the input terminal AUD is applied to the block G through resistor R14 and capacitor C11 from the transistor Q6 of block F since the block E becomes non-operative and the block F operates. Moreover, since the voice sub-carrier signal is applied to the block G through the capacitor C10 from the terminal 4 of block A, the voice sub-carrier signal is amplitude-modulated by a voice signal in the block G. Since the block E is non-operative, a voice signal is not applied to the terminal 3 of block A and the voice sub-carrier wave sent from the terminal 4 is not frequency-modulated.

As in the case of above, the output signal of block G is applied to the block L through the blocks H and I and is mixed with a video signal applied to the block L through the resistor R25 from the terminal 6 of block A. Such a mixed signal modulates the carrier in the UHF band sent from the carrier oscillator COSC and outputs a modulated signal from the output terminal RFOUT.

Since the transistor Q8 of block J is OFF, the voltage set by the variable resistor VR2 is applied to the base of transistor Q3 through the diode array DA1 in the block K and the emitter voltage of transistor Q3 is determined by the variable resistor VR2 and the block L operates in the SECAM system, namely as a video modulator of positive modulation.

Fig. 2 shows an embodiment where the transistors Q4 to Q8 of the embodiment of the present invention shown in Fig. 1 are arranged as a transistor array TA1. The same symbols as those in Fig. 1 indicate the same components. FI is the low-pass filter of block I. A indicates the block A and the transistor array TA1 has the structure indicated in Fig. 3. Namely, a terminal 1 and a terminal 7 are connected to the common collector, the terminals 2 to 6 are connected to the emitters of transistors Q4 to Q8 the terminals 12 to 8 are connected to the bases of transistors Q4 to Q8. With such a transistor array TA1, the structure for switching the modulation system corresponding to different television systems can be formed small in size.

In the embodiment described above, since emitter follower circuit are formed in the blocks E and F, an input impedance for the voice signal can be set high and such an input impedance has a high frequency characteristic. When any one of transistors Q4 and Q7 which perform switching operations is ON, the emitter voltage of the associated one of transistors Q5 and Q6 rises up to a value nearer to the collector voltage and a reverse bias of 1.8V is applied across the base and emitter, whereby, accurate switching can be ensured.

If one sets inoperative any of transistors Q5 and Q6 only by setting the operating current thereof to zero, the following problem would arise. When an input signal of 1,2 $V_{pp}$ or more, for example, is applied to the base of the transistor which has been set inoperative, the base-emitter junction of that transistor becomes conductive, leading to an amplitude-modulated component being mixed into the frequency-modulated voice subcarrier if the transistor Q6 is set inoperative, and leading to a frequency-modulated component being mixed into the amplitude-modulated voice sub-carrier if transistor Q5 is set inoperative.

On the other hand, in the block G, since a modulator is composed of a transistor Q2, the input impedance becomes high as compared with that of a modulator consisting of a diode and thereby a lesser power is required for supplying the voice sub-carrier wave and the voice signal. Moreover, less amount of carrier leaks to the voice signal, while less amount of voice signal leaks to the carrier wave signal source.

The block H forms a high-pass-filter having a capacitor C12 and a coil L5. Such a high-pass-filter is generally a T-shaped filter with the one end of the coil being grounded for rejection of a DC component. In the above embodiment, a L-shaped filter is formed by connecting the one end of coil L5 to the power source and thereby one capacitor can be eliminated from the T-shaped filter. The one end of coil L5 is equivalently grounded through an internal impedance of power supply and capacitor C15.

The block K is capable of switching the setting of bias of block L and easily switching such bias with the transistor Q8.

The present invention can easily be adopted for switching of the other television systems through the common part, as well as the PAL and SECAM systems described above.

**Claims**

1. A high frequency modulation circuit switchable to at least two different modes of modulation, characterized in that a modulating signal (AUD) is applied to two switching circuits (E, F) each of which is switchable between an ON-state in which the applied modulating signal (AUD) can pass, and an OFF-state in which the applied modulating signal (AUD) is blocked, that a carrier wave is frequency-modulated by the output signal of a first (E) one of the switching circuits (E, F) and is amplitude-modulated by the output signal of the second switching circuit (F), and that the switching circuits (E, F) are switched to different switching states by means of a switching-signal.

2. A high frequency modulation circuit according to claim 1, characterized in that each of the switching circuits (E, F) comprises an amplifying transistor (Q5, Q6) operated as an emitter follower amplifier, and a switching transistor (Q4, Q7) switching the amplifier transistor (Q5, Q6) into an amplifying state or an OFF-state under the control of the switching signal and the inverted switching signal, respectively.

3. A high frequency modulation circuit according to claim 1 or 2, characterized in that the transistors (Q4 to Q7) of the switching circuits (E, F) are arranged as a transistor array (Fig. 3).

4. A high frequency modulation circuit according to any of claims 1 to 3, characterized in that the output of the first switching circuit (E) is connected to the modulation signal input (3) of a frequency modulator (OM) and that the output of the second switching circuit (F) and the output (4) of the frequency modulator (OM) are connected to the input of an amplitude modulator (G) the output signal of which is amplitude-modulated when the second switching circuit (F) is in the ON-state and is frequency-modulated when the first switching circuit (E) is in the ON-state.

5. A high frequency modulation circuit according to any of claims 1 to 4, characterized in that the frequency of the carrier wave to be modulated is switchable between at least two frequencies by means of the switching signal (SW).

6. A high frequency modulation circuit according to claim 5, characterized in that the frequency of the carrier wave is determined by a tank circuit (B) comprising a first coil (L2) and connected in parallel thereto a series connection comprising a second coil (L3) and an electronic switch (D1) the switching state of which is controlled by the switching signal (SW).

7. A high frequency modulation circuit according to any of claims 1 to 6, characterized in that the carrier wave to be modulated is the voice sub-carrier and the modulating signal is the voice signal (AUD) of a television signal, and that the amplitude-modulated or frequency-modulated voice sub-carrier and a video-signal (VID) are applied to a picture signal modulator (L) modulating a television signal carrier.

8. A high frequency modulation circuit according to claim 7, characterized in that the picture signal modulator (L) is switchable between positive modulation and negative modulation and that the switching condition of the picture signal modulator (L) is controlled by the switching signal (SW).

## Patentansprüche

1. Hochfrequenzmodulationsschaltung, die zwischen wenigstens zwei unterschiedlichen Modulationsbetriebsarten umschaltbar ist, dadurch gekennzeichnet, daß ein Modulationssignal (AUD) zwei Schalt-Schaltungen (E, F) zugeführt wird, die je umschaltbar sind zwischen einem EIN-Zustand, in dem das zugeführte Modulationssignal (AUD) hindurch kann, und einem AUS-Zustand, in dem das zugeführte Modulationssignal (AUD) gesperrt wird, daß eine Trägerwelle vom Ausgangssignal einer ersten (E) der Schalt-Schaltungen (E, F) frequenzmoduliert und vom Ausgangssignal der zweiten Schalt-Schaltung (F) amplitudenmoduliert wird, und daß die Schalt-Schaltungen (E, F) mittels eines Schaltsignals in unterschiedliche Schaltzustände geschaltet werden.

2. Hochfrequenzmodulationsschaltung nach Anspruch 1, dadurch gekennzeichnet, daß jede der Schalt-Schaltungen (E, F) einen Verstärkungstransistor (Q5, Q6) aufweist, der als Emitterfolgerverstärker betrieben wird, und einen Schalttransistor (Q4, Q7), der den Verstärkungstransistor (Q5, Q6) unter der Steuerung des Schaltsignals bzw. des invertierten Schaltsignals in einen verstärkenden Zustand oder einen AUS-Zustand schaltet.

3. Hochfrequenzmodulationsschaltung nach Anspruch 1 oder 2, dadurch gekennzeichnet, daß die Transistoren (Q4 bis Q7) der Schalt-Schaltungen (E, F) als Transistorreihe angeordnet sind (Fig. 3).

4. Hochfrequenzmodulationsschaltung nach einem der Ansprüchel 1 bis 3, dadurch gekennzeichnet, daß der Ausgang der ersten Schalt-Schaltung (E) mit dem Modulationssignaleingang (3) eines Frequenzmodulators (OM) verbunden ist und, daß der Ausgang der zweiten Schalt-Schaltung (F) und der Ausgang (4) des Frequenzmodulators (OM) mit dem Eingang eines Amplitudenmodulators (G) verbunden sind, dessen Ausgangssignal amplitudenmoduliert ist, wenn sich die zweite Schalt-Schaltung (F) im EIN-Zustand befindet, und frequenzmoduliert ist, wenn sich die erste Schalt-Schaltung (E) im EIN-Zustand befindet.

5. Hochfrequenzmodulationsschaltung nach einem der Ansprüche 1 bis 4, dadurch gekennzeichnet, daß die Frequenz der zu modulierenden Trägerwelle mittels des Schaltsignals (SW) zwischen wenigstens zwei Frequenzen umschaltbar ist.

6. Hochfrequenzmodulationsschaltung nach Anspruch 5, dadurch gekennzeichnet, daß die Frequenz der Trägerwelle durch eine Resonanzschaltung (B) bestimmt wird, die eine erste Spule (L2) aufweist und parallel dazugeschaltet eine Reihenschaltung mit einer zweiten Spule (L3) und einem elektronischen Schalter (D1), dessen Schaltzustand durch das Schaltsignal (SW) gesteuert wird.

7. Hochfrequenzmodulationsschaltung nach einem der Ansprüchel 1 bis 6, dadurch gekennzeichnet, daß die zu modulierende Trägerwelle der Tonebenträger und das Modulationssignal das Tonsignal (AUD) eines Fernsehsignals sind und daß der amplitudenmodulierte oder frequenzmodulierte Tonebenträger und ein Videosignal (VID) einem einen Fernsehsignalträger modulierenden Bildsignalmodulator (L) zugeführt werden.

8. Hochfrequenzmodulationsschaltung nach Anspruch 7, dadurch gekennzeichnet, daß der Bildsignalmodulator (L) zwischen positiver und negativer Modulation umschaltbar ist und daß der Schaltzustand des Bildsignalmodulators (L) durch das Schaltsignal (SW) gesteuert wird.

## Revendications

1. Circuit de modulation à haute fréquence qui peut être commuté à au moins deux modes différents de modulation, caractérisé en ce qu'un signal de modulation (AUD) est appliqué à deux circuits de commutation (E, F) qui peuvent être commutés chacun entre un état de fermeture dans lequel le signal appliqué de modulation (AUD) peut passer et un état d'ouverture dans lequel le signal appliqué de modulation (AUD) est arrêté, en ce qu'une onde porteuse est modulée en fréquence par le signal de sortie d'un premier (E) des circuits de commutation (E, F) et est modulée en amplitude par le signal de sortie du second circuit de commutation (F), et en ce que les circuits de commutation (E, F) sont commutés à des états différents de commutation par un signal de commutation.

2. Circuit de modulation à haute fréquence selon la revendication 1, caractérisé en ce que chacun des circuits de commutation (E, F) comporte un transistor amplificateur (Q5, Q6) commandé comme amplificateur à charge d'émetteur, et un transistor de commutation (Q4, Q7) qui commute le transistor amplificateur (Q5, Q6) à un état d'amplification ou à un état d'ouverture sous la commande du signal commutation et du signal inverse de commutation, respectivement.

3. Circuit de modulation à haute fréquence selon la revendication 1 ou 2, caractérisé en ce que les transistors (Q4 à Q7) des circuits de commutation (E, F) sont disposés sous forme d'un réseau de transistors (figure 3).

4. Circuit de modulation à haute fréquence selon l'une quelconque des revendications 1 à 3, caractérisé en ce que la sortie du premier circuit de commutation (E) est connectée à l'entrée de signal de modulation (3) d'un modulateur de fréquence (OM), et en ce que la sortie du second circuit de commutation (F) et la sortie (4) du modulateur de fréquence (OM) sont connectées à l'entrée d'un modulateur d'amplitude (G) dont le signal de sortie est modulé en amplitude lorsque le second circuit de commutation (F) est à l'état de fermeture et est modulé en fréquence lorsque le premier circuit de commutation (E) est à l'état de fermeture.

5. Circuit de modulation à haute fréquence selon l'une quelconque des revendications 1 à 4, caractérisé en ce que la fréquence de l'onde porteuse à moduler peut être commutée entre au moins deux fréquences à l'aide du signal de commutation (SW).

6. Circuit de modulation à haute fréquence selon la revendication 5, caractérisé en ce que la fréquence de l'onde porteuse est déterminée par un circuit résonnant parallèle (B) comprenant une première self (L2) et, en parallèle par rapport à elle, une connexion série comprenant une seconde self (L3) et un commutateur électronique (D1) dont l'état de commutation est commandé par le signal de commutation (SW).

7. Circuit de modulation à haute fréquence selon l'une quelconque des revendications 1 à 6, caractérisé en ce que l'onde porteuse à moduler est la sous-porteuse de parole et le signal de modulation est le signal de parole (AUD) d'un signal de télévision, et en ce que la sous-porteuse de parole modulée en amplitude ou modulée en fréquence et un signal vidéo (VID) sont appliqués à un modulateur de signaux d'image (L) qui module une porteuse de signal de télévision.

8. Circuit de modulation à haute fréquence selon la revendication 7, caractérisé en ce que le modulateur de signaux d'image (L) peut être commuté entre une modulation positive et une modulation négative, et en ce que l'état de commutation du modulateur de signaux d'image (L) est commandé par le signal de commutation (SW).

FIG. 1

EP 0 154 318 B1

# FIG. 2

EP 0 154 318 B1

# FIG. 3